# EUROPEAN PATENT APPLICATION

(11) **EP 4 794 460 A1**
(43) Date of publication of application: **19.08.2026**
(21) Application number: 24877639.5
(22) Date of filing: 11.10.2024
(51) Int. Cl.: H05K 7/20, F28D 15/02

(54) **HEAT DISSIPATION APPARATUS**

(30) Priority: 12.10.2023 KR 20230136116; 24.10.2023 KR 20230142586; 10.10.2024 KR 20240137596
(71) Applicant: KMW Inc., Hwaseong-si, Gyeonggi-do 18462 (KR)
(72) Inventor: KIM, Duk Yong, Yongin-si Gyeonggi-do 17086 (KR); JI, Kyo Sung, Hwaseong-si Gyeonggi-do 18484 (KR); RYU, Chi Back, Hwaseong-si Gyeonggi-do 18378 (KR); SEO, Jin Kook, Busan 46726 (KR); CHOI, In Hwa, Yongin-si Gyeonggi-do 17148 (KR)
(74) Representative: impuls legal PartG mbB
(86) International application number: PCT/KR2024/096324
(87) International publication number: WO 2025/080104

(57) **Abstract**

The present invention relates to a heat dissipation apparatus comprising: an evaporation plate assembly configured to be in surface thermal contact with a heat-generating surface of a heat-generating element to receive heat, and to define a storage part storing a liquid refrigerant of refrigerant; a plurality of condensation plate assemblies coupled to the evaporation plate assembly and configured to provide a refrigerant flow space in which a vapor-phase refrigerant, phase-changed in the storage part, is diffused and condensed; and a mounting panel configured to cover the storage part of the evaporation plate assembly and to mediate coupling of the plurality of condensation plate assemblies to the evaporation plate assembly; wherein a sintered block configured to receive heat of a predetermined temperature or higher from the heat-generating element and to evaporate the liquid refrigerant into the vapor-phase refrigerant is disposed inside the storage part of the evaporation plate assembly, thereby maximizing the heat dissipation performance of the heat dissipation apparatus.

## Description

### [Technical Field]

The present disclosure relates to a heat dissipation apparatus, and more particularly, to a heat dissipation apparatus that can prevent physical vibration caused by an increase in internal pressure during vapor-liquid circulation of a refrigerant and achieve a shorter vapor-liquid circulation cycle.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation apparatuses are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation apparatus has a problem in that pressure increases as temperature rises, because temperature and pressure are proportional to each other. When pressure increases due to high temperature conducted from a heating element within the sealed heat dissipation apparatus, it may cause the heat dissipation apparatus itself to rupture. To address this problem, it is necessary to prevent the pressure from increasing, and the heat dissipation apparatus requires a sufficient internal volume to allow pressure equilibrium to be achieved during the phase-change circulation process of a substance.

Further, the thermal energy transferred to the heat dissipation apparatus should be utilized as much as possible for the phase change of the refrigerant. However, if energy is used in the vibration (movement) of the heat dissipation apparatus itself due to an increase in internal pressure, there may be a problem in that the vapor-liquid circulation cycle becomes longer, thereby degrading heat dissipation performance.

### [Disclosure]

### [Technical Problem]

The present disclosure is proposed to resolve the aforementioned technical issues and is directed to providing a heat dissipation apparatus that can minimize conversion of thermal energy, required for phase change from a liquid refrigerant into a vapor-phase refrigerant, into physical force, thereby shortening a vapor-liquid circulation cycle per unit time and consequently inducing more active vapor-liquid circulation.

Further, the present disclosure is directed to providing a heat dissipation apparatus that can improve heat dissipation performance by inducing rapid collection and movement of a liquid refrigerant, obtained by condensation of a vapor-phase refrigerant, to a region close to a heat-generating element.

Issues of the present disclosure are not limited to the above-mentioned issues, and other technical issues not mentioned above will be clearly understood by those skilled in the art from the following description.

### [Technical Solution]

A heat dissipation apparatus according to an embodiment of the present disclosure includes an evaporation plate assembly configured to be in surface thermal contact with a heat-generating surface of a heat-generating element to receive heat, and to define a storage part storing a liquid refrigerant of refrigerant, a plurality of condensation plate assemblies coupled to the evaporation plate assembly and configured to provide a refrigerant flow space in which a vapor-phase refrigerant, phase-changed in the storage part, is diffused and condensed, and a mounting panel configured to cover the storage part of the evaporation plate assembly and to mediate coupling of the plurality of condensation plate assemblies to the evaporation plate assembly, and a sintered block configured to receive heat of a predetermined temperature or higher from the heat-generating element and to evaporate the liquid refrigerant into the vapor-phase refrigerant is disposed inside the storage part of the evaporation plate assembly.

The sintered block may be formed by sintering a predetermined metal powder, and be disposed to occupy a portion of the storage part of the evaporation plate assembly.

The sintered block may have a lower surface in close contact with a bottom surface of the storage part corresponding to a relatively lower side with respect to a direction of gravity.

The sintered block may be seated on the bottom surface of the storage part such that an upper surface thereof is spaced apart by a predetermined distance from the mounting panel corresponding to an upper side of the storage part.

The sintered block may be seated to be spaced apart by a predetermined distance from each of first and second ends of the storage part in a longitudinal direction.

A range in which heat of a predetermined temperature or higher is received may be defined between the first and second ends of the storage part in the longitudinal direction.

The sintered block may be formed by sintering a metal powder of copper (Cu).

A plurality of rigidity reinforcement columns may be seated inside the storage part of the evaporation plate assembly such that at least upper ends thereof support a lower surface of the mounting panel.

The plurality of rigidity reinforcement columns may include an outer column configured to simultaneously support the bottom surface of the storage part and the lower surface of the mounting panel, and a mid column configured to simultaneously support the upper surface of the sintered block and the lower surface of the mounting panel.

Upper surfaces of the outer column and the mid column may be formed with a plurality of support grooves recessed downward, the support grooves supporting portions of lower ends of the plurality of condensation plate assemblies.

The plurality of support grooves may be spaced apart to correspond to a spacing distance in a width direction of the plurality of condensation plate assemblies.

The outer column may have a lower surface supported on the bottom surface of the storage part and an upper surface supported on the lower surface of the mounting panel, and may be disposed in close contact with each of first and second ends of the sintered block in the longitudinal direction, which is spaced apart by a predetermined distance from each of the first and second ends of the storage part in the longitudinal direction.

A plurality of liquid refrigerant collection holes may be formed in the outer column, each of the liquid refrigerant collection holes having at least an upper end height lower than a height of the upper surface of the sintered block.

The plurality of liquid refrigerant collection holes may be formed to respectively communicate with the first and second ends of the sintered block in the longitudinal direction.

The liquid refrigerant located in the storage part corresponding to an outer side of the outer column with respect to each of the first and second ends of the sintered block may be absorbed into and dispersed in the sintered block through the plurality of liquid refrigerant collection holes.

Each of the plurality of condensation plate assemblies may include a first-side heat conduction panel formed by sheet metal processing through a press forming process from a metal panel member having at least a predetermined thermal conductivity, and a second-side heat conduction panel formed by sheet metal processing through the press forming process from the same metal panel member as the first-side heat conduction panel, and may further include at least one liquid refrigerant guide column configured to guide the liquid refrigerant condensed in the refrigerant flow space to be close to each of the first and second ends of the sintered block.

When a pair of liquid refrigerant guide columns are arranged to be spaced apart by a predetermined distance, the liquid refrigerant guide columns may be arranged to be inclined such that a width thereof gradually decreases toward a lower side with respect to the direction of gravity.

When a pair of liquid refrigerant guide columns are arranged to be spaced apart by a predetermined distance, the liquid refrigerant guide columns may be arranged to be inclined such that a width thereof gradually increases toward a lower side with respect to the direction of gravity.

When a single liquid refrigerant guide column is provided, the liquid refrigerant guide column may be arranged to be inclined such that an upper end thereof is close to the first end or the second end of the sintered block, and a lower end thereof is close to the second end or the first end of the sintered block.

The heat dissipation apparatus may further include a plurality of fin reinforcement panels disposed between the plurality of condensation plate assemblies and arranged to support outer surfaces of adjacent condensation plate assemblies, respectively.

The plurality of fin reinforcement panels may be formed in a wave shape so as to have a corrugated vertical cross-section in a vertical direction.

The plurality of fin reinforcement panels may be formed in a wave shape so as to have a corrugated horizontal cross-section in a longitudinal direction.

The first-side heat conduction panel and the second-side heat conduction panel may be metal panel members made of SUS.

### [Advantageous Effects]

A heat dissipation apparatus according to the present disclosure is advantageous in that physical vibration caused by an increase in internal pressure during vapor-liquid circulation of a refrigerant is prevented, and heat dissipation performance is improved by shortening a vapor-liquid circulation cycle per unit time and thereby promoting active vapor-liquid circulation.

Effects of the present disclosure are not limited to the effects mentioned above, and other effects not mentioned above will be clearly understood by those skilled in the art from the description of the claims.

### [Description of Drawings]

FIGS. 1A and 1B are a bottom perspective view and a top perspective view illustrating a heat dissipation apparatus according to an embodiment of the present disclosure, respectively;
FIGS. 2A and 2B are exploded perspective views of FIGS. 1A and 1B;
FIG. 3 is a perspective view illustrating an evaporation plate assembly and a mounting panel among components of FIG. 1;
FIG. 4 is an exploded perspective view of FIG. 3;
FIG. 5 is a left side view of FIG. 1A;
FIG. 6 is a sectional view taken along line A-A of FIG. 5;
FIG. 7 is an exploded perspective view illustrating a state in which a single condensation plate assembly among the components of FIG. 1A is separated;
FIG. 8 is a perspective view illustrating a pair of condensation plate assemblies for explaining a fin reinforcement panel among the components of FIG. 1A;
FIG. 9 is an exploded perspective view of FIG. 8;
FIG. 10 is a perspective view illustrating a single condensation plate assembly among the components of FIG. 1A;
FIG. 11 is an exploded perspective view of FIG. 10;
FIG. 12 is a sectional view taken along line B-B of FIG. 5, illustrating various implementations of a fin column bar;
FIG. 13 is a sectional view taken along line C-C of FIG. 1A; and
FIG. 14 is a cutaway perspective view of FIG. 13 and a partially enlarged view thereof.

### <Description of reference numerals>

| | | | |
|---|---|---|---|
| 1: | Heat dissipation apparatus | 50: | Air vent tube |
| 100: | Evaporation plate assembly | 110: | Storage part |
| 160: | Sintered block | 170: | Rigidity reinforcement column |
| 171: | Outer column | 171h: | Liquid refrigerant collection hole |
| 173: | Mid column | 173h: | Dispersion hole |
| 174: | Support groove | 175: | Guide pin |
| 200: | Condensation plate assembly | 200A: | First-side heat conduction panel |
| 200B: | Second-side heat conduction panel | 205: | Refrigerant flow space |
| 210: | Edge portion | 230: | Strength reinforcement portion |
| 250: | Refrigerant guide column | 290: | Fin reinforcement panel |
| 300: | Mounting panel | 310: | Installation slit |

### [Mode for Invention]

Hereinafter, a heat dissipation apparatus according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

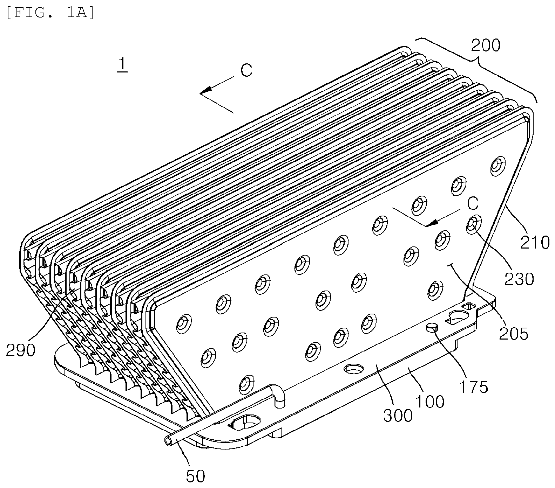

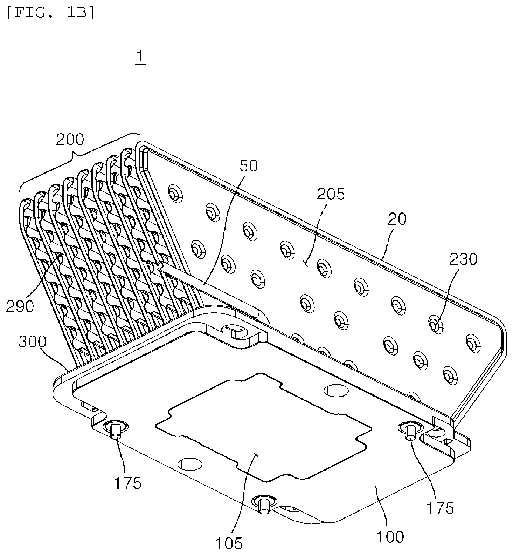

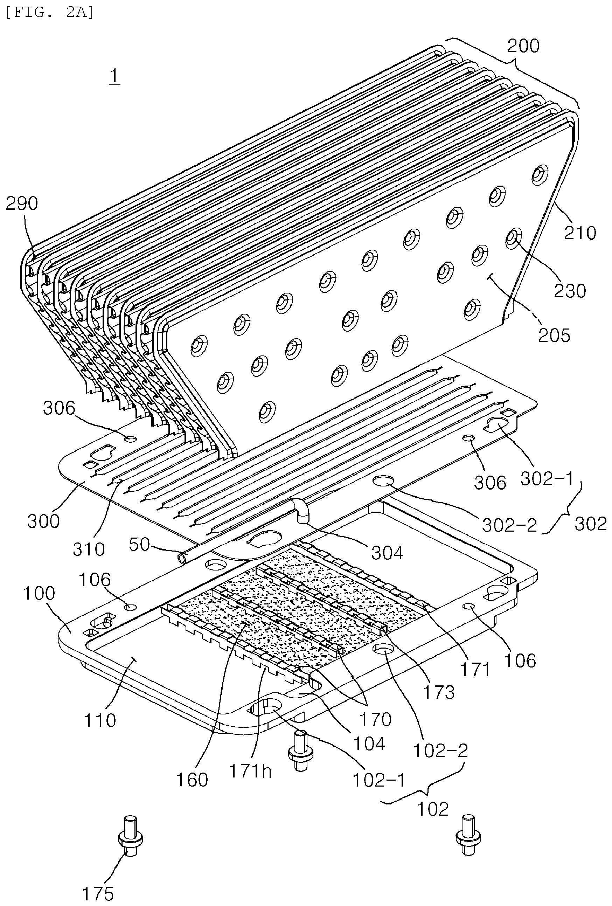

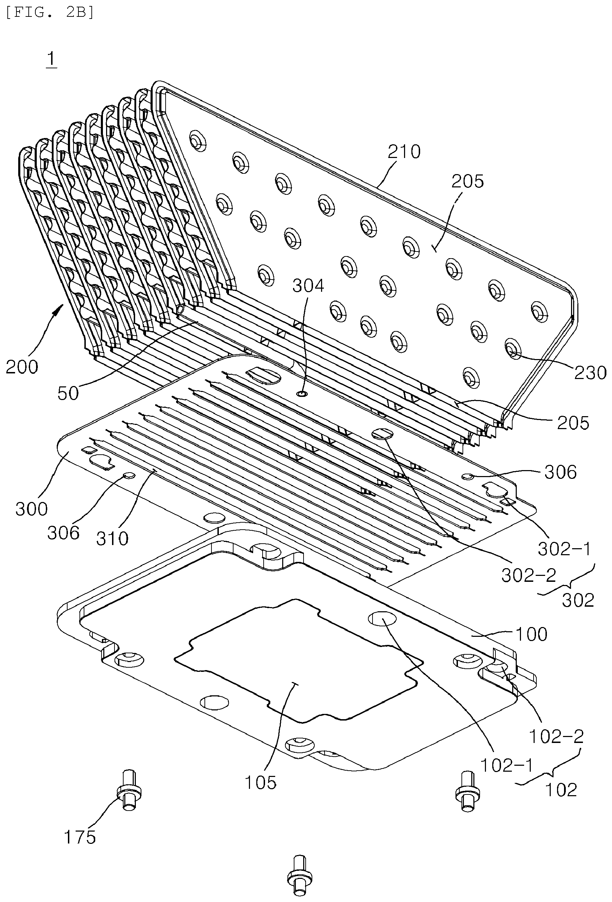

FIGS. 1A and 1B are a bottom perspective view and a top perspective view illustrating a heat dissipation apparatus according to an embodiment of the present disclosure, respectively, and FIGS. 2A and 2B are exploded perspective views of FIGS. 1A and 1B.

As shown in FIGS. 1A to 2B, a heat dissipation apparatus 1 according to embodiments of the present disclosure may include an evaporation plate assembly 100 in which a storage part 110 (see reference numeral 110 in FIG. 2A and subsequent drawings) for storing a refrigerant capable of phase change according to temperature is formed and at least a portion of a lower surface thereof is in surface thermal contact with heat-generating surfaces of heat-generating elements (not shown), and a plurality of condensation plate assemblies 200 coupled to the evaporation plate assembly 100 to communicate with the storage part 110 and configured to dissipate heat transferred from the heat-generating elements through heat exchange with outside air (outdoor air).

Here, the evaporation plate assembly 100 may be in surface thermal contact with the heat-generating surface of the heat-generating element (not shown), and the storage part 110 in which a liquid refrigerant of the refrigerant is stored may be formed therein.

In this case, the heat-generating element may be an electrically driven electronic device, and may typically be a system semiconductor device that is supplied with electrical energy to operate a system while emitting a predetermined amount of heat. However, the heat-generating element is not necessarily limited thereto, and may include any electronic device that generates heat during system operation.

Meanwhile, the plurality of condensation plate assemblies 200 may be coupled to the evaporation plate assembly 100 via a mounting panel 300 to be described later, and may serve to allow a vapor-phase refrigerant, which has undergone a phase change from the liquid refrigerant stored in the storage part 110 due to heat supplied from the heat-generating elements (not shown), to be diffused and condensed.

More specifically, the plurality of condensation plate assemblies 200 are configured to be positioned relatively above the evaporation plate assembly 100 with respect to the direction of gravity, and generally serve to provide a space (a refrigerant flow space 205 to be described later) in which the liquid refrigerant is phase-changed into the vapor-phase refrigerant by the evaporation plate assembly 100 and then diffused, while simultaneously providing a space in which the vapor-phase refrigerant is condensed back into the liquid refrigerant through heat exchange with outside air (outdoor air) so as to naturally flow downward in the direction of gravity.

The evaporation plate assembly 100 is arranged parallel to the heat-generating surfaces of the heat-generating elements and may be horizontally disposed so that the liquid refrigerant stored in the storage part 110 is not biased.

In addition, the evaporation plate assembly 100 may be provided in the form of a substantially rectangular metal panel having a small thickness in a vertical direction, and the storage part 110 formed on an upper portion thereof may also be formed in a rectangular groove shape having a longitudinal direction in which a distance between one end and the other end is long.

Here, the evaporation plate assembly 100 may serve to receive heat from the heat-generating surfaces of the heat-generating elements (not shown), which inevitably generate heat while being electrically driven, such as electronic devices, and to evaporate the liquid refrigerant stored in the storage part 110 into the vapor-phase refrigerant.

To this end, a thermal contact portion 105 that is in direct surface thermal contact with the heat-generating surfaces of the heat-generating elements may be formed on a lower surface of the evaporation plate assembly 100.

Further, since the evaporation plate assembly 100 serves to phase-change the liquid refrigerant stored in the storage part 110 into the vapor-phase refrigerant using heat supplied from the heat-generating elements, it is preferably made of a metal material having excellent thermal conductivity. Among metal materials, copper (Cu), which is most suitable in terms of cost and performance in the relevant industry, may be adopted.

In addition, the condensation plate assembly 200 may be provided to communicate with the storage part 110 of the evaporation plate assembly 100 via the mounting panel 300, and may serve to dissipate heat supplied from the heat-generating elements to the outside through heat exchange with outside air (outdoor air) during a process in which the vapor-phase refrigerant, phase-changed in the evaporation plate assembly 100, is diffused and flows and is then condensed back into the liquid refrigerant.

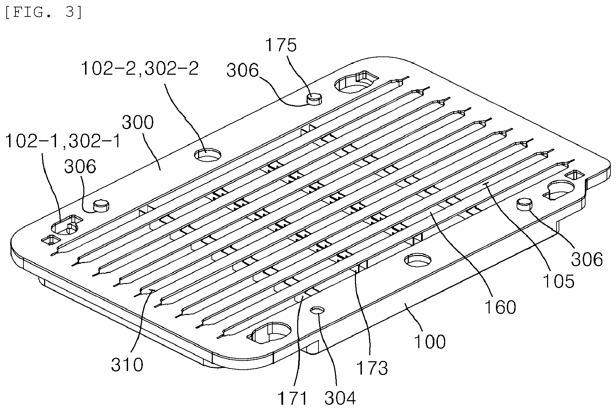

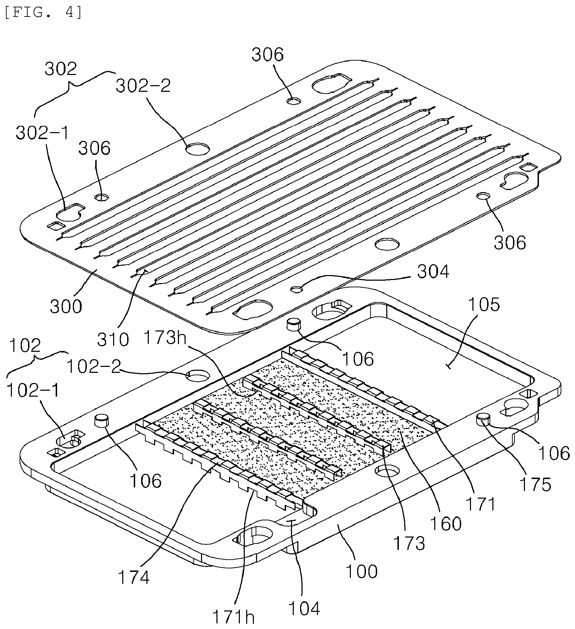

FIG. 3 is a perspective view illustrating the evaporation plate assembly and the mounting panel among components of FIG. 1, and FIG. 4 is an exploded perspective view of FIG. 3.

As shown in FIGS. 3 and 4, in the evaporation plate assembly 100, the storage part 110 may be formed at a central portion of an upper surface thereof in a groove shape having a predetermined depth so as to have a substantially rectangular horizontal cross-section.

Here, the liquid refrigerant is stored in the storage part 110, and an upper opened portion thereof may be covered by the mounting panel 300, to be described later, which mediates coupling of the condensation plate assembly 200 to the evaporation plate assembly 100.

**More** specifically, the plurality of condensation plate assemblies 200 may be coupled to the evaporation plate assembly 100 via the mounting panel 300. Here, when the evaporation plate assembly 100 is provided in the form of a substantially rectangular panel having rounded corner portions, the mounting panel 300 may also be provided in a panel shape that may entirely cover the upper surface of the evaporation plate assembly 100.

Here, the mounting panel 300 is provided to cover the storage part 110 of the evaporation plate assembly 100, and may serve to allow portions of the plurality of condensation plate assemblies 200 to be inserted and supported.

To this end, the mounting panel 300 may be formed with a plurality of installation slits 310 into which the plurality of condensation plate assemblies 200 are individually inserted, the installation slits being elongated in a longitudinal direction and cut so as to communicate with the storage part 110 and the refrigerant flow spaces 205 of the plurality of condensation plate assemblies 200.

That is, the plurality of condensation plate assemblies 200 may be individually installed in the plurality of installation slits 310 formed in the mounting panel 300, and the storage part 110 of the evaporation plate assembly 100 may be shielded from the outside by hermetically installing the condensation plate assemblies in the mounting panel 300 so as to prevent leakage of the refrigerant to the outside while communicating with the refrigerant flow spaces 205 of the plurality of condensation plate assemblies 200.

A plurality of screw assembly holes 102 and a plurality of screw fastening holes 302 may be formed at an edge portion of the evaporation plate assembly 100 and an edge portion of the mounting panel 300, respectively, for mutual assembly via mounting fastening members (not shown) to be described later.

More specifically, the plurality of screw assembly holes 102 may include first assembly holes 102-1 formed to penetrate vertically at one end and the other end in a longitudinal direction on the edge portion of the evaporation plate assembly 100, and a second assembly hole 102-2 formed to penetrate vertically at a central portion in a width direction on the edge portion of the evaporation plate assembly 100.

In addition, the plurality of screw fastening holes 302 may also be formed in the mounting panel 300, and may include first fastening holes 302-1 formed to penetrate vertically at positions corresponding to the first assembly holes 102-1 of the evaporation plate assembly 100, and a second fastening hole 302-2 formed to penetrate vertically at a position corresponding to the second assembly hole 102-2 of the evaporation plate assembly 100.

Here, the mounting fastening members may be fastened via fastening bosses (not shown) coupled to the plurality of screw assembly holes 102 and the plurality of screw fastening holes 302.

The evaporation plate assembly 100 and the mounting panel 300 coupled by the mounting fastening members may be sealed so as to prevent leakage of the liquid refrigerant (or the vapor-phase refrigerant) stored in the storage part 110 defined therein.

Here, since it is necessary to prevent leakage of the liquid refrigerant not only between the evaporation plate assembly 100 and the mounting panel 300 but also between the plurality of installation slits 310 formed in the mounting panel 300 and the plurality of condensation plate assemblies 200 coupled thereto, the plurality of condensation plate assemblies 200 may be coupled to the plurality of installation slits 310, respectively, by a coupling method capable of preventing leakage, such as welding.

In addition, a vacuum groove 104 for installing an air vent tube 50, which will be described later, to communicate therewith may be further formed in a groove shape on at least one position of the edge portion of the evaporation plate assembly 100.

More specifically, the vacuum groove 104 may be formed to communicate with the storage part 110. In particular, the vacuum groove 104 may be formed in a groove shape with a portion of the edge portion of the evaporation plate assembly 100 removed, and may be formed in a shape in which at least a portion of an end contacting the storage part 110 is removed.

Meanwhile, a tube installation hole 304 for fixed installation of the air vent tube 50, which will be described later, may be formed through at least one position of the edge portion of the mounting panel 300, that is, a position corresponding to the vacuum groove 104 of the evaporation plate assembly 100, so as to communicate with the vacuum groove 104.

In the heat dissipation apparatus 1 according to an embodiment of the present disclosure, when the refrigerant undergoing phase change is filled therein, as in the condensation plate assembly 200, a vacuumizing process for vacuumizing the refrigerant flow space 205 is essential so as to respond to variations in internal pressure generated during the phase change, and the above-described vacuumizing process may be performed through the air vent tube 50 coupled via the vacuum groove 104 of the evaporation plate assembly 100 and the tube installation hole 304 of the mounting panel 300.

After the vacuumizing process is completed, an air tube caulking process may be performed to block communication with the outside after cutting the air vent tube 50. However, it is not necessarily required to cut the air vent tube 50, and it is sufficient to perform the caulking process so as to block an airflow path of the air vent tube 50.

Meanwhile, in the heat dissipation apparatus 1 according to an embodiment of the present disclosure, as shown in FIGS. 3 and 4, a sintered block 160, which receives heat of a predetermined temperature or higher from the heat-generating element(s) and evaporates the liquid refrigerant into the vapor-phase refrigerant, may be disposed inside the storage part 110 of the evaporation plate assembly 100.

The sintered block 160 may be formed by sintering a predetermined metal powder. In addition, the sintered block 160 may be disposed so as to occupy a portion of the storage part 110 of the evaporation plate assembly 100.

In this case, a lower surface of the sintered block 160 may be in close contact with a bottom surface of the storage part 110 corresponding to a relatively lower side with respect to the direction of gravity. Further, the sintered block 160 may be seated on the bottom surface of the storage part 110 such that an upper surface thereof is spaced apart by a predetermined distance from the mounting panel 300 corresponding to an upper side of the storage part 110.

More specifically, the sintered block 160 is formed to have a thickness such that, while being seated on the bottom surface of the storage part 110, an upper surface thereof does not come into contact with the mounting panel 300.

Here, when the storage part 110 of the evaporation plate assembly 100 is formed in a long rectangular shape in a longitudinal direction, the sintered block 160 may have a shape close to a square and may be seated at a central portion of the storage part 110, excluding respective portions at one end and the other end in the longitudinal direction.

More specifically, the sintered block 160 may be seated so as to be spaced apart by a predetermined distance from each of one end and the other end of the storage part 110 in the longitudinal direction.

Thus, a range in which the sintered block 160 receives heat of a predetermined temperature or higher may be defined between one end and the other end of the storage part 110 in the longitudinal direction.

When the liquid refrigerant condensed through heat exchange with outside air (outdoor air) in the refrigerant flow space 205 of the plurality of condensation plate assemblies 200 to be described later flows downward in the direction of gravity, if it falls onto an upper surface of the sintered block 160, it may be absorbed and stored through the upper surface of the sintered block 160, and if it falls between respective portions at one end and the other end of the storage part 110 where the sintered block 160 is not provided, it may be absorbed into and stored in the sintered block 160 through respective thickness portions (side surfaces) of the sintered block 160.

In addition, among the components of the heat dissipation apparatus 1 according to an embodiment of the present disclosure, the above-described evaporation plate assembly 100 and at least one guide pin 175 to be described later may be redefined as a heat transfer plate assembly for substantially transferring heat generated from the heat-generating element(s) to the above-described condensation plate assembly 200.

That is, the heat transfer plate assembly may further include at least one guide pin 175 for guiding coupling of the above-described evaporation plate assembly 100 and mounting panel 300.

At least one guide pin 175 may serve to identify a correct position for coupling and to induce mutual coupling at the correct position while being inserted into guide pin installation holes 106 and 306 formed in the evaporation plate assembly 100 and the mounting panel 300.

More specifically, a plurality of guide pin installation holes 106 for insertion of the at least one guide pin 175 may be formed at three spaced positions on the edge portion of the evaporation plate assembly 100, and guide pin installation holes may also be formed at three corresponding spaced positions in the mounting panel 300.

Here, an upper end of the guide pin 175 may be inserted into the guide pin installation hole 106 of the evaporation plate assembly 100 and may protrude by a predetermined length above an upper surface of the evaporation plate assembly 100, and, upon installation of the mounting panel 300, may be inserted into the guide pin installation hole 306 of the mounting panel 300, thereby enabling installation at the correct position.

For reference, a total of four guide pin installation holes 306 may be formed in the mounting panel 300, and among the four guide pin installation holes 306, one located at a portion where the above-described vacuum groove 104 is formed may be replaced with the above-described tube installation hole 304.

In addition, a lower end of the guide pin 175 may also protrude by a predetermined length from a lower surface of the evaporation plate assembly 100, and the protruding lower end of the guide pin 175 may serve to mediate coupling with an additional component to be installed or with a component such as a housing (not shown) in which the heat-generating elements are provided.

Such at least one guide pin 175 may be formed of a ceramic material.

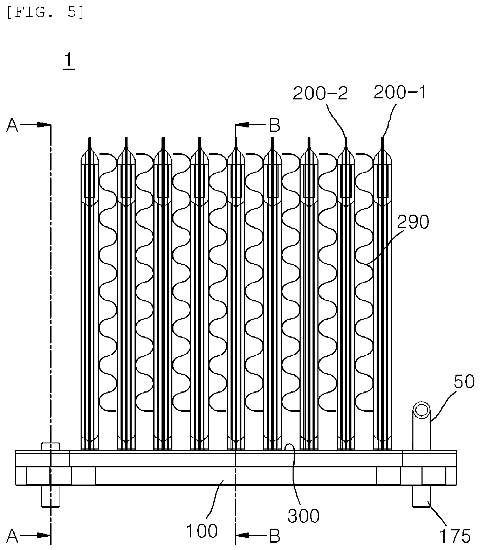

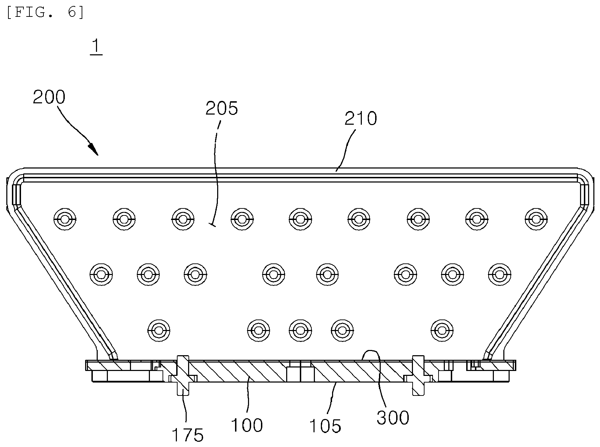

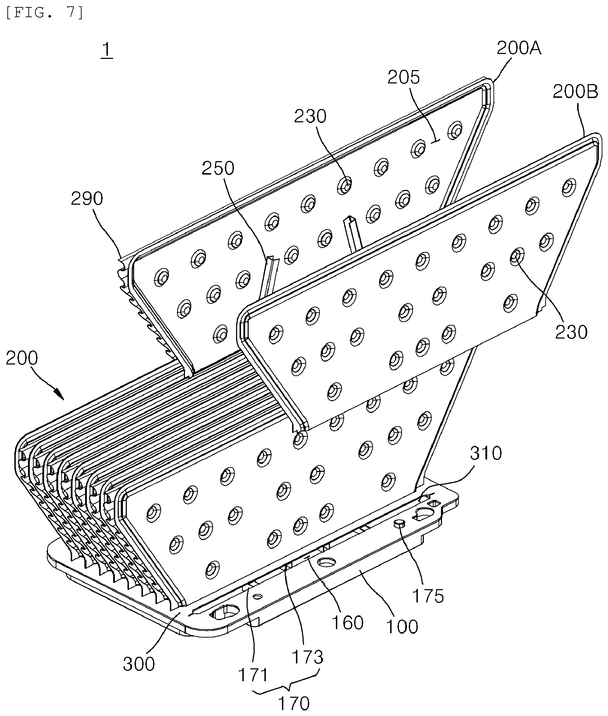

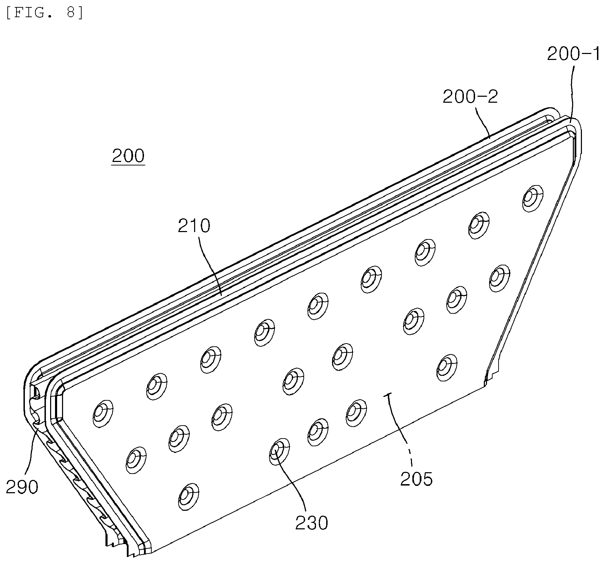

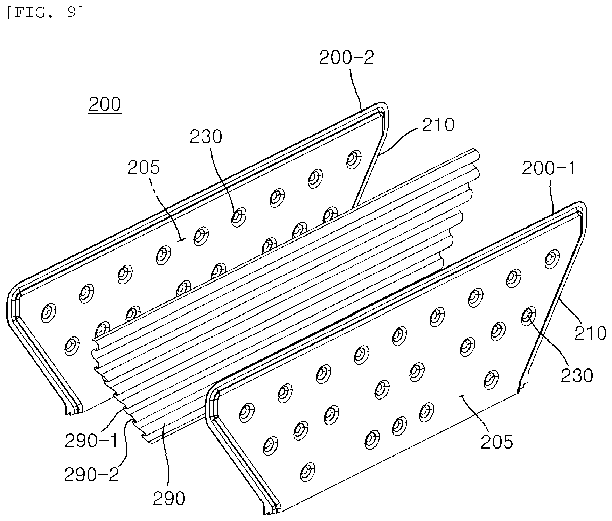

FIG. 5 is a left side view of FIG. 1A, FIG. 6 is a sectional view taken along line A-A of FIG. 5, FIG. 7 is an exploded perspective view illustrating a state in which a single condensation plate assembly among the components of FIG. 1A is separated, FIG. 8 is a perspective view illustrating a pair of condensation plate assemblies for explaining a fin reinforcement panel among the components of FIG. 1A, and FIG. 9 is an exploded perspective view of FIG. 8.

As shown in FIGS. 3 to 9, a plurality of rigidity reinforcement columns 170 may be seated inside the storage part 110 of the evaporation plate assembly 100 such that at least upper ends thereof support the lower surface of the mounting panel 300.

More specifically, the plurality of rigidity reinforcement columns 170 may be provided to simultaneously support the bottom surface of the storage part 110 and the lower surface of the mounting panel 300, or to simultaneously support the upper surface of the sintered block 160 and the lower surface of the mounting panel 300.

Here, the plurality of rigidity reinforcement columns 170 may include outer columns 171 that simultaneously support the bottom surface of the storage part 110 and the lower surface of the mounting panel 300, and mid columns 173 that simultaneously support the upper surface of the sintered block 160 and the lower surface of the mounting panel 300.

Upper surfaces of the outer columns 171 and the mid columns 173 may be formed with a plurality of support grooves 174 that are recessed downward and support portions of lower ends of the plurality of condensation plate assemblies 200.

Here, since the plurality of support grooves 174 respectively support the plurality of condensation plate assemblies 200, it is preferable that the support grooves are formed spaced apart to correspond to a spacing distance in a width direction of the plurality of condensation plate assemblies 200.

Further, a widthwise size of each of the plurality of support grooves 174 may be formed to correspond to a thickness of the lower end of each condensation plate assembly 200.

Here, when the plurality of condensation plate assemblies 200 are installed such that portions of the lower ends thereof are immersed in the liquid refrigerant stored in the storage part 110 of the evaporation plate assembly 100 through the installation slits 310 formed in the mounting panel 300, the assembly process may be stabilized by allowing the condensation plate assemblies to be supported in advance by the plurality of support grooves 174 formed on upper surfaces of the outer columns 171 and the mid columns 173 before being coupled by various fixing methods such as welding.

In particular, the plurality of condensation plate assemblies 200 are seated at their lower ends in the plurality of support grooves 174 formed at upper ends of the plurality of outer columns 171 and the mid columns 173, respectively, thereby making it possible to maintain the coupling force of various fixing methods such as the above-described welding even when excessive external force is applied to the plurality of condensation plate assemblies 200.

Meanwhile, a pair of outer columns 171 may be arranged to be spaced apart from each other, with one column at each of one end and the other end in the longitudinal direction of the storage part 110 of the evaporation plate assembly 100.

More specifically, each outer column 171 may have a lower surface supported and seated on the bottom surface of the storage part 110, and an upper surface supported by the lower surface of the mounting panel 300.

In this case, as described above, a plurality of installation slits 310 for installing the plurality of condensation plate assemblies 200 are formed in the mounting panel 300, and the upper surface of the outer column 171 (and the mid column 173 to be described later) may be designed to support a lower surface of the mounting panel 300 at portions where the plurality of installation slits 310 are not formed, or a lower surface of the mounting panel 300 corresponding to regions between the installation slits 310.

Here, the pair of outer columns 171 may be arranged to be in close contact with one end and the other end of the sintered block 160 in the longitudinal direction, which are spaced apart by a predetermined distance from one end and the other end of the storage part 110 in the longitudinal direction.

A plurality of liquid refrigerant collection holes 171h, each having a height smaller than that of the upper surface of the sintered block 160, may be formed in the outer columns 171.

The plurality of liquid refrigerant collection holes 171h may be formed to respectively communicate with one end and the other end of the sintered block 160 in the longitudinal direction.

The plurality of liquid refrigerant collection holes 171h are formed to have a size not greater than a thickness of the sintered block 160 (a distance between the upper surface and the lower surface thereof). Thus, when the liquid refrigerant condensed in the refrigerant flow space 205 of the condensation plate assembly 200 flows downward to the storage part 110 of the evaporation plate assembly 100 on a lower side in the direction of gravity, the liquid refrigerant permeates through the sidewall portion of the sintered block 160 and is absorbed and dispersed.

Meanwhile, the pair of outer columns 171 disposed in close contact with both ends of the sintered block 160 in the longitudinal direction may serve to prevent the liquid refrigerant condensed in the refrigerant flow space 205 of the plurality of condensation plate assemblies 200 from overflowing outward when it directly falls onto the upper portion of the sintered block 160.

Such a structure is a design that can significantly shorten the vapor-liquid circulation cycle by allowing the liquid refrigerant, which directly falls onto the sintered block 160, to be immediately evaporated in an evaporable region.

To this end, the outer columns 171 may be provided as a pair and disposed to be in close contact with one end and the other end of the sintered block 160, and heights of upper ends thereof may be formed to be at least higher than the upper surface of the sintered block 160.

Meanwhile, the mid columns 173 may be provided as a pair and may be spaced apart from each other on the upper surface of the sintered block 160 between the pair of outer columns 171.

Here, the lower surfaces of the pair of mid columns 173 are supported on the upper surface of the sintered block 160, and a plurality of dispersion holes 173h may be formed at lower ends of the mid columns 173 to serve as passages so that a vapor-phase refrigerant phase-changed in the sintered block 160 within the storage part 110 of the evaporation plate assembly 100 is uniformly dispersed over the upper surface of the sintered block 160.

In this case, the plurality of dispersion holes 173h may also serve to allow the liquid refrigerant to pass therethrough and be uniformly distributed when the condensed liquid refrigerant is excessively stored in the storage part 110, thereby preventing non-uniform evaporation within the sintered block 160.

Meanwhile, the sintered block 160 is formed by sintering metal powder, and may have a plurality of pores through which at least the liquid refrigerant may permeate by surface tension or capillary force.

In this case, the metal powder may be made of copper (Cu). Here, the plurality of pores may be naturally formed when copper powder is sintered.

For reference, in the heat dissipation apparatus 1 according to an embodiment of the present disclosure, the evaporation plate assembly 100 may be provided by processing a metal panel made of the same copper (Cu) material as the sintered block 160, and the condensation plate assembly 200 may be provided by processing a base panel made of SUS having a lower thermal conductivity than copper.

The evaporation plate assembly 100 configured as described above may be provided to be in surface thermal contact with the heat-generating surfaces of the heat-generating elements, respectively, and may serve as a heat dissipation plate that phase-changes the liquid refrigerant stored in the storage part 110 therein into the vapor-phase refrigerant by heat supplied from the heat-generating elements.

The heat-generating surfaces of the heat-generating elements may be directly in surface thermal contact with the thermal contact portion 105 on the lower surface of the evaporation plate assembly 100, or may be indirectly in surface thermal contact via a heat transfer medium (not shown).

The evaporation plate assembly 100 may be made of a metal material having excellent thermal conductivity. Preferably, the evaporation plate assembly 100 may be made of copper (Cu), and, except for the edge portion for coupling with the mounting panel 300, a portion in which the storage part 110 directly receiving heat from the heat-generating elements is formed may be formed to have a thickness as thin as possible.

Meanwhile, in the mounting panel 300 that covers an upper surface of the storage part 110 of the evaporation plate assembly 100, the plurality of installation slits 310 for spaced installation of the plurality of condensation plate assemblies 200 may be formed to penetrate in a vertical direction.

More specifically, when the mounting panel 300 is provided as a rectangular metal panel member elongated in a left-right direction, and lower ends 240 of the condensation plate assemblies 200 are installed to extend in the left-right direction, the plurality of installation slits 310 may be formed to be spaced apart in a width direction defined as a front-rear direction.

Here, since a portion of the evaporation plate assembly 100 forming the storage part 110 is a metal panel member made of copper (Cu) and has relatively low strength (hardness), weak rigidity between the evaporation plate assembly 100 and the mounting panel 300 may be reinforced by the plurality of rigidity reinforcement columns 170 described above.

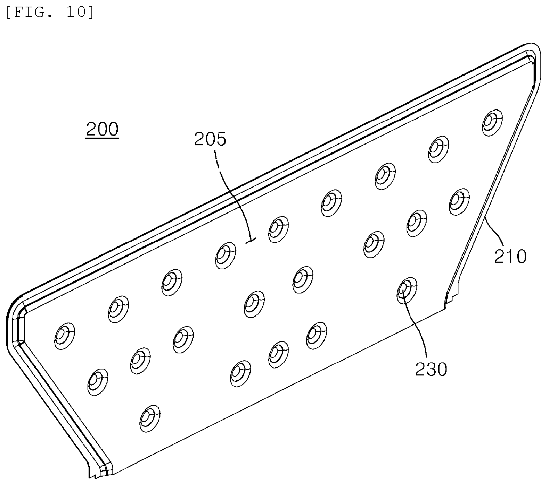

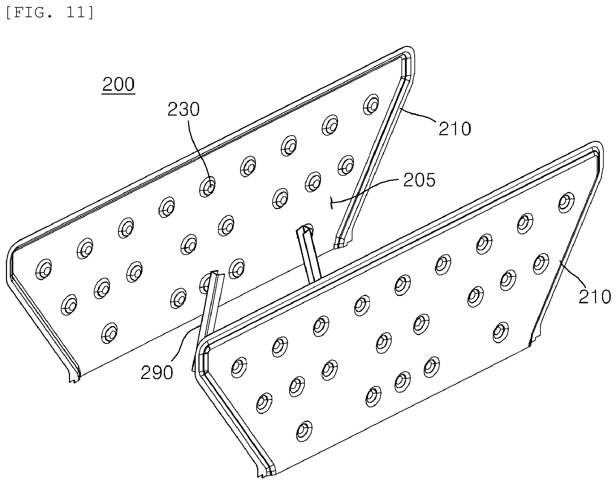

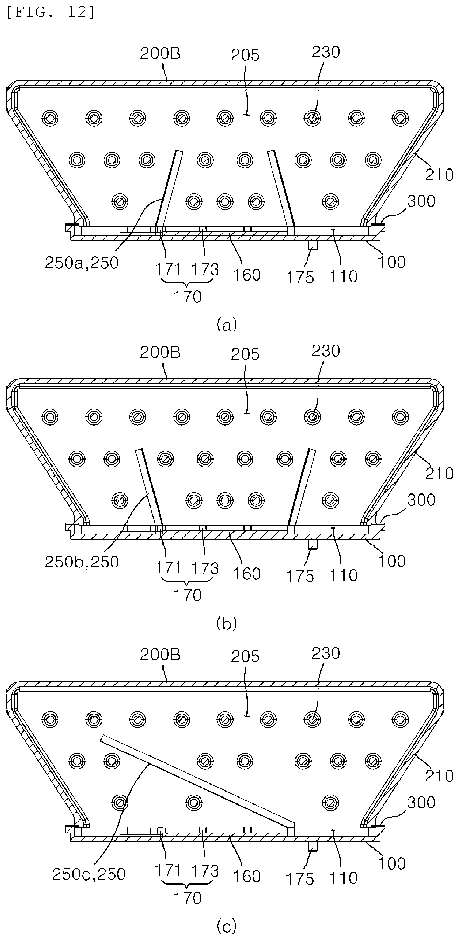

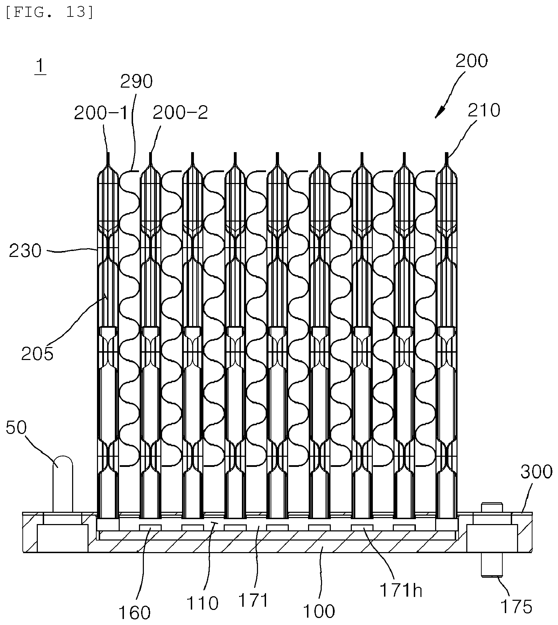

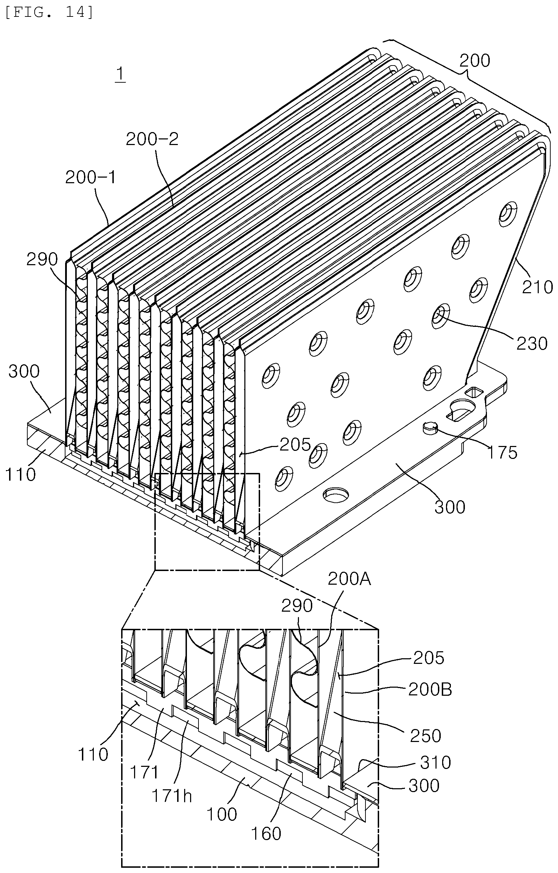

FIG. 10 is a perspective view illustrating a single condensation plate assembly among the components of FIG. 1A, FIG. 11 is an exploded perspective view of FIG. 10, FIG. 12 is a sectional view taken along line B-B of FIG. 5, illustrating various implementations of a fin column bar, FIG. 13 is a sectional view taken along line C-C of FIG. 1A, and FIG. 14 is a cutaway perspective view of FIG. 13 and a partially enlarged view thereof.

In the heat dissipation apparatus 1 according to an embodiment of the present disclosure, the plurality of condensation plate assemblies 200 coupled to the upper surface of the evaporation plate assembly 100 via the mounting panel 300 may include a first-side heat conduction panel 200A and a second-side heat conduction panel 200B, as shown in FIGS. 10 to 14.

Here, the first-side heat conduction panel 200A and the second-side heat conduction panel 200B may each be a metal panel member having a predetermined or higher thermal conductivity, and may be formed by sheet metal processing using a press forming process.

More specifically, the first-side heat conduction panel 200A and the second-side heat conduction panel 200B may be formed by sheet metal processing of a base metal panel member through the above-described press forming process into a trapezoidal shape in which upper and lower sides are parallel to each other, and a length of the lower side coupled to the evaporation plate assembly 100 is smaller than a length of the upper side.

That is, the first-side heat conduction panel 200A and the second-side heat conduction panel 200B may be coupled to protrude upward so as to be perpendicular to the upper surface of the evaporation plate assembly 100, and as the internal refrigerant flow space 205 gradually widens toward the upper side, a heat dissipation area with respect to outside air (outdoor air) may gradually increase.

In addition, in the first-side heat conduction panel 200A and the second-side heat conduction panel 200B, an edge portion 210 for mutual joining, a plurality of strength reinforcement portions 230 to be described later, and the refrigerant flow space 205 may be simultaneously formed during sheet metal processing by the press forming process.

More specifically, the first-side heat conduction panel 200A and the second-side heat conduction panel 200B may be sheet-metal processed into mutually symmetrical shapes through the above-described press forming process, and then the edge portions 210, except for the lower ends to be coupled to the evaporation plate assembly 100, may be joined through a joining process to define the refrigerant flow space 205 therein.

More specifically, the first-side heat conduction panel 200A and the second-side heat conduction panel 200B may be mutually joined by joining the edge portions 210 and the plurality of strength reinforcement portions 230, which are simultaneously formed during sheet metal processing through the press forming process, through a joining process, thereby sealing the refrigerant flow space 205 except for the lower end that is a coupling portion to the evaporation plate assembly 100. In this case, the joining process may include a welding method, and the welding method may include laser welding and brazing.

Meanwhile, the plurality of strength reinforcement portions 230 may be formed, during sheet metal processing through the press forming process, to be recessed from an outer side of each of the first-side heat conduction panel 200A and the second-side heat conduction panel 200B toward an inner side where the refrigerant flow space 205 is formed, in a dot shape or an elliptical shape.

Here, the plurality of strength reinforcement portions 230 may be formed at positions symmetric to each other in the first-side heat conduction panel 200A and the second-side heat conduction panel 200B, and may be provided such that recessed portions in the refrigerant flow space 205 are in surface contact with each other, and the contacting portions may be joined by the welding method including laser welding or brazing.

The plurality of strength reinforcement portions 230 formed as such may also serve to reinforce intrinsic rigidity of the first-side heat conduction panel 200A and the second-side heat conduction panel 200B during sheet metal processing by the press forming process.

In addition, when the refrigerant undergoes phase change within the refrigerant flow space 205, internal pressure may increase as an expansion pressure. In this case, the plurality of strength reinforcement portions 230 prevent a change in a distance between outer surfaces of the first-side heat conduction panel 200A and the second-side heat conduction panel 200B, thereby allowing thermal energy provided from the heat-generating elements to be involved only in the phase change of the refrigerant without being converted into physical force, and thus enabling smoother vapor-liquid circulation.

Meanwhile, each of the plurality of condensation plate assemblies 200 may further include at least one liquid refrigerant guide column 250 for guiding the liquid refrigerant condensed in the refrigerant flow space 205 to be close to one end and the other end of the sintered block 160.

As shown in FIGS. 12(a) and 12(b), when a pair of liquid refrigerant guide columns 250a and 250b are disposed to be spaced apart by a predetermined distance, they may be arranged to be inclined such that a width thereof gradually decreases toward a lower side with respect to the direction of gravity (see FIG. 12(b)), or gradually increases toward the lower side with respect to the direction of gravity (see FIG. 12(a)).

In this case, lower ends of the liquid refrigerant guide columns 250a and 250b are preferably arranged to correspond to one end and the other end of the sintered block 160, respectively.

In addition, when a single liquid refrigerant guide column 250c is provided as shown in FIG. 12(c), it may be inclined such that an upper end thereof is close to one end of the sintered block 160 and a lower end thereof is close to the other end of the sintered block 160. Conversely, it may be inclined such that the upper end thereof is close to the other end of the sintered block 160 and the lower end thereof is close to the one end of the sintered block 160.

Referring to FIGS. 10 to 14, a method of manufacturing the condensation plate assembly 200 according to an embodiment of the present disclosure will be briefly described as follows.

First, a metal panel member serving as a base material and preferably made of SUS may be formed into a first-side heat conduction panel 200A and a second-side heat conduction panel 200B by sheet metal processing through a press forming process such that left and right portions are symmetrical with respect to a central portion in a longitudinal direction.

In particular, during the press forming process, the refrigerant flow space 205 may be formed to have a predetermined thickness inside the first-side heat conduction panel 200A and the second-side heat conduction panel 200B, and edge portions 210 may be simultaneously processed and formed so as to be mutually joinable such that the refrigerant flow space 205, except for the lower end 240 to be coupled to the evaporation plate assembly 100, is sealed.

Further, during the press forming process, a plurality of strength reinforcement portions 230 for mutual joining by the welding method within the refrigerant flow space 205 between the first-side heat conduction panel 200A and the second-side heat conduction panel 200B may be simultaneously processed and formed.

After the edge portions 210 and the strength reinforcement portions 230 are formed through the press forming process, the edge portions 210 and the strength reinforcement portions 230 of the first-side heat conduction panel 200A and the second-side heat conduction panel 200B may be joined by a welding method through a joining process, thereby defining the refrigerant flow space 205 therein.

Meanwhile, as shown in FIGS. 5 to 9, the heat dissipation apparatus 1 according to an embodiment of the present disclosure may further include fin reinforcement panels 290 disposed between the plurality of condensation plate assemblies 200 and arranged to support outer surfaces of adjacent condensation plate assemblies 200, respectively.

Here, the fin reinforcement panel 290 may be formed in a wave shape so as to have a corrugated vertical cross-section in a vertical direction.

However, the corrugated cross-section of the fin reinforcement panel 290 is not necessarily limited to a vertical cross-section in the vertical direction. Although not shown in the drawings, it may be formed in a wave shape so as to have a corrugated horizontal cross-section in a longitudinal direction.

A protruding portion 290-1 on one side of the fin reinforcement panel 290 may be coupled to contact an outer surface of an adjacent condensation plate assembly (reference numeral 200-2 in FIG. 9), and a protruding portion 290-2 on the other side of the fin reinforcement panel 290 may be coupled to contact an outer surface of another adjacent condensation plate assembly (reference numeral 200-1 in FIG. 9).

As such, the fin reinforcement panel 290 is disposed between the plurality of condensation plate assemblies 200, and each of the protruding portions 290-1 and 290-2 is supported to contact outer surfaces of adjacent condensation plate assemblies 200, thereby preventing vibration (movement) of the condensation plate assemblies 200 during heat dissipation due to phase change of the refrigerant and maintaining stable coupling. In addition, similarly to the function of the plurality of strength reinforcement portions 230 described above, two fin reinforcement panels 290 may be provided to support the plurality of condensation plate assemblies 200 from outer sides thereof, thereby preventing thermal energy supplied from the heat-generating elements from being converted into physical energy unrelated to heat dissipation and helping to achieve higher heat dissipation performance.

Further, the fin reinforcement panel 290 is made of a metal material having a certain level of thermal conductivity, and is provided to be in contact with the outer surfaces of the first-side heat conduction panel 200A and the second-side heat conduction panel 200B that substantially perform heat exchange with outside air (outdoor air), thereby increasing an overall heat exchange area and further improving heat dissipation performance.

As described above, a heat dissipation apparatus 1 according to embodiments of the present disclosure has been described in detail with reference to the accompanying drawings. However, embodiments of the present disclosure are not necessarily limited to the above-described embodiment, and it will be apparent that various modifications and equivalent implementations are possible by those skilled in the art. Therefore, the true scope of the present disclosure is defined by the claims set forth below.

## Claims

1. A heat dissipation apparatus comprising:
an evaporation plate assembly configured to be in surface thermal contact with a heat-generating surface of a heat-generating element to receive heat, and to define a storage part storing a liquid refrigerant of refrigerant;
a plurality of condensation plate assemblies coupled to the evaporation plate assembly and configured to provide a refrigerant flow space in which a vapor-phase refrigerant, phase-changed in the storage part, is diffused and condensed; and
a mounting panel configured to cover the storage part of the evaporation plate assembly and to mediate coupling of the plurality of condensation plate assemblies to the evaporation plate assembly;
wherein a sintered block configured to receive heat of a predetermined temperature or higher from the heat-generating element and to evaporate the liquid refrigerant into the vapor-phase refrigerant is disposed inside the storage part of the evaporation plate assembly.

2. The heat dissipation apparatus of claim 1, wherein the sintered block is formed by sintering a predetermined metal powder, and is disposed to occupy a portion of the storage part of the evaporation plate assembly.

3. The heat dissipation apparatus of claim 1, wherein the sintered block has a lower surface in close contact with a bottom surface of the storage part corresponding to a relatively lower side with respect to a direction of gravity.

4. The heat dissipation apparatus of claim 3, wherein the sintered block is seated on the bottom surface of the storage part such that an upper surface thereof is spaced apart by a predetermined distance from the mounting panel corresponding to an upper side of the storage part.

5. The heat dissipation apparatus of claim 1, wherein the sintered block is seated to be spaced apart by a predetermined distance from each of first and second ends of the storage part in a longitudinal direction.

6. The heat dissipation apparatus of claim 1, wherein a range in which heat of a predetermined temperature or higher is received is defined between the first and second ends of the storage part in the longitudinal direction.

7. The heat dissipation apparatus of any one of claims 1 to 6, wherein the sintered block is formed by sintering a metal powder of copper.

8. The heat dissipation apparatus of any one of claims 1 to 6, wherein a plurality of rigidity reinforcement columns are seated inside the storage part of the evaporation plate assembly such that at least upper ends thereof support a lower surface of the mounting panel.

9. The heat dissipation apparatus of claim 8, wherein the plurality of rigidity reinforcement columns comprise:
an outer column configured to simultaneously support the bottom surface of the storage part and the lower surface of the mounting panel; and
a mid column configured to simultaneously support the upper surface of the sintered block and the lower surface of the mounting panel.

10. The heat dissipation apparatus of claim 9, wherein upper surfaces of the outer column and the mid column are formed with a plurality of support grooves recessed downward, the support grooves supporting portions of lower ends of the plurality of condensation plate assemblies.

11. The heat dissipation apparatus of claim 10, wherein the plurality of support grooves are spaced apart to correspond to a spacing distance in a width direction of the plurality of condensation plate assemblies.

12. The heat dissipation apparatus of claim 9, wherein the outer column has a lower surface supported on the bottom surface of the storage part and an upper surface supported on the lower surface of the mounting panel, and is disposed in close contact with each of first and second ends of the sintered block in the longitudinal direction, which is spaced apart by a predetermined distance from each of the first and second ends of the storage part in the longitudinal direction.

13. The heat dissipation apparatus of claim 12, wherein a plurality of liquid refrigerant collection holes are formed in the outer column, each of the liquid refrigerant collection holes having at least an upper end height lower than a height of the upper surface of the sintered block.

14. The heat dissipation apparatus of claim 13, wherein the plurality of liquid refrigerant collection holes are formed to respectively communicate with the first and second ends of the sintered block in the longitudinal direction.

15. The heat dissipation apparatus of claim 13, wherein the liquid refrigerant located in the storage part corresponding to an outer side of the outer column with respect to each of the first and second ends of the sintered block is absorbed into and dispersed in the sintered block through the plurality of liquid refrigerant collection holes.

16. The heat dissipation apparatus of claim 1, wherein each of the plurality of condensation plate assemblies comprises:
a first-side heat conduction panel formed by sheet metal processing through a press forming process from a metal panel member having at least a predetermined thermal conductivity; and
a second-side heat conduction panel formed by sheet metal processing through the press forming process from the same metal panel member as the first-side heat conduction panel; and
further comprises at least one liquid refrigerant guide column configured to guide the liquid refrigerant condensed in the refrigerant flow space to be close to each of the first and second ends of the sintered block.

17. The heat dissipation apparatus of claim 16, wherein, when a pair of liquid refrigerant guide columns are arranged to be spaced apart by a predetermined distance, the liquid refrigerant guide columns are arranged to be inclined such that a width thereof gradually decreases toward a lower side with respect to the direction of gravity.

18. The heat dissipation apparatus of claim 16, wherein, when a pair of liquid refrigerant guide columns are arranged to be spaced apart by a predetermined distance, the liquid refrigerant guide columns are arranged to be inclined such that a width thereof gradually increases toward a lower side with respect to the direction of gravity.

19. The heat dissipation apparatus of claim 16, wherein, when a single liquid refrigerant guide column is provided, the liquid refrigerant guide column is arranged to be inclined such that an upper end thereof is close to the first end or the second end of the sintered block, and a lower end thereof is close to the second end or the first end of the sintered block.

20. The heat dissipation apparatus of claim 1, further comprising:
a plurality of fin reinforcement panels disposed between the plurality of condensation plate assemblies and arranged to support outer surfaces of adjacent condensation plate assemblies, respectively.

21. The heat dissipation apparatus of claim 20, wherein the plurality of fin reinforcement panels are formed in a wave shape so as to have a corrugated vertical cross-section in a vertical direction.

22. The heat dissipation apparatus of claim 20, wherein the plurality of fin reinforcement panels are formed in a wave shape so as to have a corrugated horizontal cross-section in a longitudinal direction.

23. The heat dissipation apparatus of claim 16, wherein the first-side heat conduction panel and the second-side heat conduction panel are metal panel members made of SUS.
